(19) Europäisches Patentamt

European Patent Office

Office européen des brevets

(11) EP 1 146 323 A1

(12) DEMANDE DE BREVET EUROPEEN

(43) Date de publication:
17.10.2001 Bulletin 2001/42

(51) Int Cl.⁷: $G01H\ 1/14$, $H03H\ 17/02$

(21) Numéro de dépôt: 01400863.5

(22) Date de dépôt: 04.04.2001

(84) Etats contractants désignés:
AT BE CH CY DE DK ES FI FR GB GR IE IT LI LU
MC NL PT SE TR
Etats d'extension désignés:
AL LT LV MK RO SI

(30) Priorité: 14.04.2000 FR 0004833

(71) Demandeur: SAGEM SA
75016 Paris (FR)

(72) Inventeur: Forti, Olivier Roland
95310 Saint Ouen L'Aumone (FR)

(74) Mandataire: Gorrée, Jean-Michel
Cabinet Plasseraud,
84, rue d'Amsterdam
75440 Paris Cédex 09 (FR)

(54) Procédé et dispositif pour detecter la présence et l'energie d'une fréquence donnée dans un bruit, et application a la détection du cliquetis dans un moteur a combustion interne

(57) L'invention concerne la détection, par analyse spectrale, de la présence et de l'énergie d'une fréquence donnée ($F_o$) dans un bruit, consistant : à échantillonner le bruit avec une fréquence d'échantillonnage ($F_e$) ; à effectuer un filtrage anti-repliement sur le signal échantillonné, et à traiter le signal échantillonné en le filtrant avec un filtre numérique et en évaluant, sur la base d'un critère prédéterminé, la présence et l'énergie de ladite fréquence donnée ($F_o$).

Le filtrage numérique est un filtrage passe-haut ayant une fréquence de coupure ($F_c$) ; la fréquence d'échantillonnage ($F_e$) est double de la fréquence donnée ($F_o$) ; et la fréquence de coupure du filtrage anti-repliement est située entre la fréquence donnée ($F_o$) et la fréquence d'échantillonnage ($F_e$).

**Description**

La présente invention concerne des perfectionnements apportés dans le domaine de la détection, par analyse spectrale, de la présence et de l'énergie d'une fréquence donnée dans un bruit.

Ce type de détection peut trouver une application très intéressante, bien que non exclusive, pour détecter le cliquetis dans un moteur à combustion interne. On rappellera que le cliquetis est un bruit engendré dans au moins un cylindre du moteur en raison d'une auto-inflammation locale du mélange gazeux due à une surpression avant l'apparition de l'étincelle, en raison d'un réglage défectueux de l'allumage.

Pour ce qui est de la détection du cliquetis, on connaît un dispositif réalisé sous forme d'un circuit intégré spécialisé (ASIC) qui effectue la détection et le filtrage de la fréquence du cliquetis et qui fournit un signal proportionnel à l'importance du cliquetis. Toutefois ce dispositif connu est d'un coût trop élevé pour qu'il soit possible d'envisager son implantation systématique dans les véhicules pour le contrôle permanent des conditions de fonctionnement du moteur.

Il est connu de détecter, par analyse spectrale, la présence et l'énergie d'une fréquence donnée $F_O$ dans un bruit. Pour cela, on échantillonne le signal du bruit détecté à une fréquence fixe d'échantillonnage qui est au moins double de la fréquence maximale de la bande de fréquence à analyser centrée sur la fréquence donnée $F_O$. Un filtrage anti-repliement (destiné à éliminer le signal virtuel dû à l'échantillonnage), du type passe-bas fixe, coupe les fréquences supérieures à ladite fréquence maximale. Un filtre numérique passe-bande centré sur la fréquence donnée $F_O$ traite le signal dans la plage ainsi définie et on évalue alors, à partir d'un critère d'évaluation prédéterminé appliqué dans la bande filtrée, la présence et l'importance de la fréquence donnée $F_O$.

Un inconvénient de ce processus connu réside dans le fait que, lorsque la fréquence donnée $F_O$ à analyser est variable (ce qui est le cas pour le cliquetis), il est nécessaire de recalculer le filtre numérique passe-bande pour chaque valeur de la fréquence $F_O$.

Un autre inconvénient du processus connu réside dans le fait que la fréquence d'échantillonnage est fixe et supérieure à au moins deux fois la fréquence maximale de la bande de fréquence à analyser centrée sur la fréquence donnée $F_O$. Par exemple pour un cas typique où $F_O$ = 20 kHz et la largeur de bande BW = 8 kHz, la fréquence d'échantillonnage doit être supérieure à 2 ($F_O$ + ½ BW) = 48 kHz, c'est-à-dire en pratique au moins 60 kHz pour que le filtre antirepliement soit d'un ordre raisonnable.

Par conséquent, le processus connu peut certes être mis en oeuvre en laboratoire lorsqu'on dispose du temps et des moyens permettant d'adapter les conditions de calcul aux valeurs effectives de la fréquence à analyser. Toutefois, ce processus n'est par contre pas adapté pour traiter une fréquence $F_O$ évolutive, comme l'est le cliquetis, ce qui est à considérer conjointement avec la nécessité d'un échantillonnage à une fréquence élevée. En définitive, le processus sus-indiqué ne peut pas être mis en oeuvre pour effectuer une analyse continue, notamment pour assurer un contrôle en temps réel des conditions de fonctionnement du moteur et éventuellement engendrer un signal propre à commander une modification appropriée du circuit d'allumage.

L'invention a essentiellement pour but de proposer des perfectionnements aptes à écarter les inconvénients précités des moyens actuellement connus et qui soient plus simples à mettre en oeuvre et plus économiques, de sorte qu'il soit envisageable, dans le cas de l'application à la détection du cliquetis, de créer un dispositif permettant de suivre en continu, en temps réel, le fonctionnement du moteur d'un véhicule automobile, notamment pour assurer un ajustement permanent des moyens d'allumage.

A ces fins, l'invention propose, selon un premier de ses aspects, un procédé pour détecter, par analyse spectrale, la présence et l'énergie d'une fréquence donnée $F_O$ dans un bruit, ce procédé consistant :

- à échantillonner le bruit avec une fréquence d'échantillonnage $F_e$ ;
- à effectuer un filtrage anti-repliement sur le signal échantillonné,
- et à traiter le signal échantillonné

  • en le filtrant avec un filtre numérique et
  • en évaluant, sur la base d'un critère prédéterminé, la présence et l'énergie de ladite fréquence donnée $F_O$,

lequel procédé, étant conforme à l'invention, se caractérise en ce que :

- le filtrage numérique est un filtrage passe-haut ayant une fréquence de coupure $F_c$,
- la fréquence d'échantillonnage $F_e$ est double de la fréquence donnée $F_O$, et
- la fréquence de coupure du filtrage anti-repliement est située entre la fréquence donnée $F_O$ et la fréquence d'échantillonnage $F_e$.

Les dispositions propres à l'invention confèrent des avantages qui permettent de simplifier les conditions de détection de la fréquence donnée $F_O$ présente dans le bruit.

Le principe de repliement de spectre (théorème de Shannon) implique que le filtrage généré par le filtrage numérique passe-haut à fréquence de coupure $F_c$ est équivalent à un filtrage passe-bande de fréquence centrale $F_O$ = $F_e$/2 et ayant un coefficient de qualité Q qui est fonction de la fréquence d'échantillonnage $F_e$ et de ladite fréquence de coupure $F_c$.

Lorsqu'on souhaite détecter plusieurs fréquences données $F_O$ différentes, il suffit alors de modifier la fréquence d'échantillonnage $F_e$, tout en gardant les mêmes coefficients de filtrage pour régler le filtrage sur une autre valeur de fréquence donnée $F_o$.

Dans ces conditions, l'échantillonnage peut être effectué avec une fréquence $F_e$ qui est toujours inférieure à 2 $F_o$ max, c'est-à-dire inférieure à 40 kHz pour $F_o$ = 20 kHz, à comparer avec la fréquence supérieure à 60 kHz avec la technique du filtrage passe-bande utilisée jusqu'à présent.

La fréquence du filtrage anti-repliement doit également être réglable afin que cette fréquence anti-repliement demeure comprise entre la fréquence maximale de la bande ($F_{max} = F_o$ + ½ largeur de bande) et la fréquence d'échantillonnage, de manière à éliminer le repliement de spectre lié aux fréquences autour de n $F_e + F_e/2$, n étant un nombre entier.

De préférence, la fréquence de coupure $F_c$ du filtrage numérique passe-haut est choisie de manière à simplifier les coefficients du filtre passe-haut. Pour cela il suffit de prendre

$$F_c = (F_e \cdot \text{arctg } n)/\pi$$

où n est un nombre entier.

Plus la valeur de n est grande, plus la fréquence de coupure $F_c$ est proche de la valeur de la fréquence donnée $F_o = F_e/2$, et donc plus le facteur de qualité Q du filtrage passe-bande équivalent est élevé.

Le procédé conforme à l'invention peut trouver une application préférée pour la détection et la quantification d'un cliquetis de fréquence donnée $F_o$ dans un moteur à combustion interne.

Selon un second de ses aspects, l'invention propose un dispositif de détection, par analyse spectrale, de la présence et de l'énergie d'une fréquence donnée $F_o$ dans un bruit, ce dispositif comportant :

- des moyens d'échantillonnage du signal de bruit avec une fréquence d'échantillonnage $F_e$,
- des moyens de filtrage anti-repliement du signal échantillonné, et
- des moyens de traitement du signal échantillonné comprenant

  • des moyens de filtrage numérique et
  • des moyens d'évaluation, sur la base d'un critère donné, de la présence et de l'énergie de ladite fréquence prédéterminée,

  lequel dispositif, étant agencé conformément à l'invention, se caractérise en ce que :
- les moyens de filtrage numérique sont du type passe-haut,
- la fréquence d'échantillonnage $F_e$ est double de la fréquence donnée $F_o$, et
- la fréquence de coupure des moyens de filtrage anti-repliement est comprise entre ladite fréquence donnée $F_o$ et ladite fréquence d'échantillonnage $F_e$.

De préférence alors, les moyens de filtrage numérique passe-haut possèdent une fréquence de coupure $F_c$ dont la valeur est choisie de façon à simplifier les coefficients desdits moyens de filtrage numérique passe-haut. Dans ce cas, il est avantageux que la fréquence de coupure $F_c$ des moyens de filtrage numérique passe-haut soit choisie en fonction de la fréquence d'échantillonnage $F_e$ de manière telle que soit satisfaite la relation

$$F_c = (F_e \cdot \text{arctg } n)/\pi$$

où n est un nombre entier.

Pour la détection de diverses fréquences données $F_o$, le dispositif peut avantageusement comporter des moyens pour modifier la fréquence d'échantillonnage et des moyens pour modifier la fréquence du filtre anti-repliement de façon que celle-ci demeure comprise entre la fréquence donnée $F_o$ et la fréquence d'échantillonnage $F_e$. On constitue ainsi un dispositif particulièrement simple de structure et d'utilisation, car la détection de plusieurs fréquences données $F_o$ nécessite uniquement un ajustement de fréquence (fréquence d'échantillonnage), ce que l'on sait réaliser par des moyens techniques connus (glissement de fréquence), tandis que les coefficients du filtre numérique passe-haut demeurent inchangés.

Grâce à l'invention, on recueille les avantages inhérents à une fréquence d'échantillonnage notablement plus faible que dans les dispositifs antérieurs. Les coefficients du filtre numérique passe-haut sont simples et demeurent fixes quelle que soit la fréquence $F_o$ à analyser. L'implémentation du filtre numérique est obtenue en utilisant uniquement des valeurs entières, ce qui conduit à une structure technique plus simple.

Un dispositif conforme à l'invention peut alors trouver une utilisation préférée en tant que dispositif de détection du cliquetis dans un moteur à combustion interne sous forme d'un matériel de structure simplifiée et donc moins coûteux que les dispositifs antérieurs.

Surtout, en mettant en oeuvre des moyens calculateurs puissants à microprocesseur qui sont actuellement disponibles sur le marché et qui peuvent autoriser l'élaboration d'appareils peu encombrants, et en conjonction avec les avantages inhérents à la réduction de la fréquence d'échantillonnage et à l'utilisation de filtres à coefficients entiers, il devient possible dans ce contexte de concevoir des dispositifs embarqués propres à détecter le cliquetis en permanence au cours du fonctionnement du moteur et d'assurer un suivi continu des conditions de fonctionnement du moteur qui, par un bouclage approprié sur les moyens d'allumage, permet de maintenir ce fonctionnement dans des conditions optimales.

**Revendications**

1. Procédé pour détecter, par analyse spectrale, la présence et l'énergie d'une fréquence donnée ($F_o$) dans un bruit, ce procédé consistant :

   - à échantillonner le bruit avec une fréquence d'échantillonnage ($F_e$) ;
   - à effectuer un filtrage anti-repliement sur le signal échantillonné,
   - et à traiter le signal échantillonné

     • en le filtrant avec un filtre numérique et
     • en évaluant, sur la base d'un critère prédéterminé, la présence et l'énergie de ladite fréquence donnée ($F_o$),

   **caractérisé en ce que** :

   - le filtrage numérique est un filtrage passe-haut ayant une fréquence de coupure ($F_c$),
   - la fréquence d'échantillonnage ($F_e$) est double de la fréquence donnée ($F_o$), et
   - la fréquence de coupure du filtrage anti-repliement est située entre la fréquence donnée ($F_o$) et la fréquence d'échantillonnage ($F_e$).

2. Procédé selon la revendication 1, **caractérisé en ce que** la fréquence de coupure ($F_c$) du filtrage passe-haut est choisie de manière à simplifier les coefficients du filtre passe-haut.

3. Procédé selon la revendication 2, **caractérisé en ce que** la fréquence de coupure ($F_c$) du filtrage numérique passe-haut est choisie telle que :

   $$F_c = (F_e \cdot \text{arctg } n)/\pi$$

   où $F_e$ est la fréquence d'échantillonnage et n est un nombre entier.

4. Procédé selon l'une quelconque des revendications précédentes, **caractérisé en ce que**, pour détecter des fréquences données ($F_o$) différentes, on modifie la fréquence d'échantillonnage tout en conservant les mêmes coefficients de filtrage passe-haut et **en ce que** la fréquence du filtrage anti-repliement est modifiée pour demeurer comprise entre la fréquence donnée ($F_o$) et la fréquence d'échantillonnage ($F_e$).

5. Procédé selon l'une quelconque des revendications précédentes, **caractérisé en ce qu'**il est mis en oeuvre pour détecter et quantifier un cliquetis de fréquence ($F_o$) dans un moteur à combustion interne.

6. Dispositif de détection, par analyse spectrale, de la présence et de l'énergie d'une fréquence donnée ($F_o$) dans un bruit, ce dispositif comportant :

   - des moyens d'échantillonnage du signal de bruit avec une fréquence d'échantillonnage ($F_e$),
   - des moyens de filtrage anti-repliement du signal échantillonné, et
   - des moyens de traitement du signal échantillonné comprenant

     • des moyens de filtrage numérique et
     • des moyens d'évaluation, sur la base d'un critère donné, de la présence et de l'énergie de ladite fréquence prédéterminée,

   **caractérisé en ce que** :

   - les moyens de filtrage numérique sont du type passe-haut,
   - la fréquence d'échantillonnage ($F_e$) est double de la fréquence donnée ($F_o$), et
   - la fréquence de coupure des moyens de filtrage anti-repliement est comprise entre ladite fréquence donnée ($F_o$) et ladite fréquence d'échantillonnage ($F_e$).

7. Dispositif selon la revendication 6, **caractérisé en ce que** les moyens de filtrage numérique passe-haut possèdent une fréquence de coupure ($F_c$) dont la valeur est choisie de façon à simplifier les coefficients desdits moyens de filtrage numérique passe-haut.

8. Dispositif selon la revendication 7, **caractérisé en ce que** la fréquence de coupure ($F_c$) des moyens de filtrage numérique passe-haut est choisie en fonction de la fréquence d'échantillonnage ($F_e$) de manière telle que soit satisfaite la relation

   $$F_c = (F_e \cdot \text{arctg } n)/\pi$$

   où n est un nombre entier.

9. Dispositif selon l'une quelconque des revendications 6 à 8, pour la détection de diverses fréquences données ($F_o$), **caractérisé en ce qu'**il comporte des moyens pour modifier la fréquence d'échantillonnage et des moyens pour modifier la fréquence du filtre anti-repliement de façon qu'elle demeure comprise entre la fréquence donnée ($F_o$) et la fréquence d'échantillonnage.

10. Utilisation du dispositif selon l'une quelconque des revendications 6 à 9 pour la détection du cliquetis

de fréquence donnée ($F_o$) dans un moteur à combustion interne.

**Office européen des brevets**

## RAPPORT DE RECHERCHE EUROPEENNE

Numéro de la demande

EP 01 40 0863

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | DE 34 26 779 A (HILBERG WOLFGANG;BERMBACH RAINER) 30 janvier 1986 (1986-01-30) * page 4, ligne 4 - ligne 32 * --- | 1,6 | G01H1/14 H03H17/02 |
| A | US 4 584 869 A (FRODSHAM JOHN S) 29 avril 1986 (1986-04-29) * colonne 6, ligne 27 - ligne 42 * --- | 1,5,6,10 | |
| A | DE 43 08 796 A (SEELIGER ANDREAS PROF DR ING ;BURGWINKEL PAUL DR ING (DE); GEROPP) 22 septembre 1994 (1994-09-22) ------ | | |

**DOMAINES TECHNIQUES RECHERCHES (Int.Cl.7)**

G01H
H03H
G01L

Le présent rapport a été établi pour toutes les revendications

| Lieu de la recherche | Date d'achèvement de la recherche | Examinateur |
|---|---|---|
| LA HAYE | 16 mai 2001 | Swartjes, H |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**   EP 01 40 0863

La présente annexe indique les membres de la famille de brevets relatifs aux documents brevets cités dans le rapport de recherche européenne visé ci–dessus.
Lesdits members sont contenus au fichier informatique de l'Office européen des brevets à la date du
Les renseignements fournis sont donnés à titre indicatif et n'engagent pas la responsabilité de l'Office européen des brevets.

16-05-2001

| Document brevet cité au rapport de recherche | Date de publication | Membre(s) de la famille de brevet(s) | Date de publication |
|---|---|---|---|
| DE 3426779 A | 30-01-1986 | AUCUN | |
| US 4584869 A | 29-04-1986 | EP 0102779 A<br>JP 59090028 A | 14-03-1984<br>24-05-1984 |
| DE 4308796 A | 22-09-1994 | AUCUN | |

EPO FORM P0460